# EUROPEAN PATENT SPECIFICATION

(11) **EP 1 929 319 B1**
(45) Date of publication and mention of the grant of the patent: **22.04.2009**
(21) Application number: 06809338.4
(22) Date of filing: 19.09.2006
(51) Int. Cl.: G01R 33/12

(54) **MAGNETIC SENSOR DEVICE WITH FILTERING MEANS**
MAGNETFELD-SENSOR MIT FILTER
DETECTEUR MAGNETIQUE A FILTRE

(30) Priority: 22.09.2005 EP 05108744
(43) Date of publication of application: 11.06.2008
(73) Proprietor: Koninklijke Philips Electronics N.V., 5621 BA Eindhoven (NL)
(72) Inventor: DE BOER, Bart Michiel, 52066 Aachen (DE); JANSEN, Theodorus Petrus Henricus Gerardus, 52066 Aachen (DE)
(74) Representative: Schouten, Marcus Maria
(86) International application number: PCT/IB2006/053361
(87) International publication number: WO 2007/034408

(56) References cited:
- WO-A-20/05010543
- GB-A- 2 252 835
- US-A- 3 681 689

## Description

The invention relates to a magnetic sensor device comprising at least one magnetic field generator, at least one associated magnetic sensor element, a current supply, and an amplifier. Moreover, the invention relates to the use of such a magnetic sensor device.

From the WO 2005/010543 A1 and WO 2005/010542 A2 a microsensor device is known which may for example be used in a microfluidic biosensor for the detection of (e.g. biological) molecules labeled with magnetic beads. The microsensor device is provided with an array of sensors comprising wires for the generation of an alternating magnetic field of a first frequency f₁ and Giant Magneto Resistances (GMR) for the detection of stray fields generated by magnetized beads. The signal of the GMRs is then indicative of the number of the beads near the sensor.

It is known to use a high frequency f₁ for the generated magnetic fields such that the magnetic signal appears in the spectrum at a frequency where not the 1/f noise but the thermal white noise is dominant in the voltage of the GMR. It is further known that a strong crosstalk signal at the bead excitation frequency f₁ appears at the GMR sensor output due to parasitic capacitance and inductive coupling between the current wires and the GMR. This signal interferes with the magnetic signal from the beads. The crosstalk between field generating means and the GMR sensors can be suppressed by modulating the sensor current of the GMR sensor with a second frequency f₂. The introduction of a modulation of the sensor current has the effect that a magnetic signal does not appear at frequency f₁ (which is overlapped by crosstalk), but at the frequencies f₁ ± f₂ (which are free of crosstalk).

In spite of the described measures for improving the signal-to-noise ratio (SNR), the magnetic sensor devices remain difficult to realize due to the extreme noise requirements of the small sensor signal.

Based on this situation it was an object of the present invention to provide means for a further improvement of the signal-to-noise ratio in a magnetic sensor device of the kind described above.

This object is achieved by a magnetic sensor device according to claim 1 and a use according to claim 11. Preferred embodiments are disclosed in the dependent claims.

A magnetic sensor device according to the present invention comprises the following components:
a) At least one magnetic field generator for generating a magnetic field of a first frequency f₁ in an adjacent investigation region. The magnetic field generator may for example be realized by a wire on a substrate of a microsensor.
b) At least one magnetic sensor element that is associated with the aforementioned magnetic field generator in the sense that it is in the reach of effects caused by the magnetic field of the magnetic field generator. The magnetic sensor element may particularly be a magneto-resistive element of the kind described in the WO 2005/010543 A1 or WO 2005/010542 A2, especially a GMR, a TMR (Tunnel Magneto Resistance), or an AMR (Anisotropic Magneto Resistance). Moreover, the magnetic sensor can be any suitable sensor based on the detection of the magnetic properties of particles to be measured on or near to the sensor surface. Therefore, the magnetic sensor is designable as a coil, magneto-resistive sensor, magneto-restrictive sensor, Hall sensor, planar Hall sensor, flux gate sensor, SQUID (Semiconductor Superconducting Quantum Interference Device), magnetic resonance sensor, or as another sensor actuated by a magnetic field.
c) A sensor supply unit for providing an alternating sensor current of a second frequency f₂ to the magnetic sensor element in such a way that the output of the magnetic sensor element contains a signal related to effects of the alternating magnetic field at the absolute frequency difference Δf between the second and the first frequency, i.e. Δf= |f₂-f₁|. The sensor supply unit may for example be realized as a current source, which by definition (ideally) supplies a constant current irrespective of the connected load, or as a voltage source, which by definition (ideally) supplies a constant voltage irrespective of the connected load.
d) A filter that is functionally disposed between the sensor supply unit and the magnetic sensor element for preventing noise in the output of the sensor supply unit from reaching the magnetic sensor element. Said filter will be called the "first filter" in the following to distinguish it from other filters introduced later. The suppressed noise is particularly one of frequencies other than the second frequency f₂.

In practice it turns out that sensor supply units like current or voltage sources for generating a sensor current of the second frequency f₂ that fulfill the abovementioned extreme noise requirements are difficult to realize. The proposed introduction of the (first) filter behind the output of the sensor supply unit helps however to improve the quality of the sensor current provided to the magnetic sensor element significantly. At the same time, design restrictions with respect to the sensor supply unit itself can be relieved.

The first filter may preferably be realized by a high pass filter with an edge frequency above the frequency difference Δf. Here and in the following, the "edge frequency" is defined as usual as the frequency at which the filter has a dampening of - 3dB. Due to the edge frequency above Δf, the first filter suppresses noise components of said and lower frequencies which would affect the signal of the magnetic sensor element one is actually interested in. Moreover, the edge frequency should of course be below the second frequency f₂ such that the effective power of the sensor supply unit can pass unimpeded. This embodiment of the first filter is therefore particularly suited if f₂ is larger than Δf, which is for example the case if a second frequency f₂ close to, or larger than, the first frequency f₁ is used.

In an alternative situation, i.e. if the second frequency f₂ is smaller than the frequency difference Δf, the first filter is preferably realized by a low pass filter with an edge frequency below the frequency difference Δf. Moreover, the edge frequency shall be above the second frequency f₂ such that the effective power of the sensor supply unit can pass unimpeded. This embodiment of the first filter is particularly suited if the second frequency f₂ is low compared to the first frequency f₁.

According to a further development of the invention, the magnetic sensor device comprises an amplifier for amplifying an output signal of the magnetic sensor element. The term "amplifier" may in this respect denote a single component (e.g. a transistor) as well as a circuit of several components that cooperate to amplify an input signal.

In a preferred variant of the aforementioned embodiment, the magnetic sensor device comprises a second filter that is functionally disposed between the magnetic sensor element and the amplifier for preventing signal components of the second frequency f₂ from reaching the amplifier. These signal components, which are present at the magnetic sensor element due to its coupling to the sensor supply unit, can therefore not introduce disturbances at the amplifier and the subsequent processing stages.

According to a first preferred realization, the aforementioned second filter is a low pass filter with an edge frequency above the frequency difference Δf. Moreover, the edge frequency should be below the second frequency f₂. This embodiment is suited for the case that the second frequency f₂ is larger than Δf, which is particularly the case for high second frequencies f₂.

Alternatively, the second filter may be realized as a high pass filter with an edge frequency below the frequency Δf. Moreover, the edge frequency should be above the second frequency f₂. This embodiment is suited for the case that f₂ is smaller than Δf which is particularly the case for low second frequencies f₂.

When both the first and the second filter are used, the ratio between the input impedance of the second filter together with the amplifier on the one hand side and the impedance of the magnetic sensor element on the other hand side is preferably larger than 1, most preferably larger than 100, wherein the impedances are considered at the second frequency f₂ and/or in a frequency region around f₂. Thus signals of the second frequency f₂ will primarily flow through the magnetic sensor element and will not reach the amplifier. It should be noted that here and in the following the "ratio" of impedances is understood to be the absolute value or modulus of a (possibly) complex quotient.

Moreover, the ratio between the output impedance of the first filter on the one hand side and the input impedance of the second filter together with the amplifier on the other hand side is preferably larger than 1, most preferably larger than 100, wherein the impedances are considered at the frequency difference Δf and/or in a frequency region around Δf. Thus the desired signals at frequency Δf will primarily flow to the amplifier for further processing and will not be lost to the sensor supply unit.

According to a further development of the invention, the magnetic sensor device comprises a compensation unit connected to the magnetic sensor element for supplying a crosstalk compensation signal of the first frequency f₁. The crosstalk compensation signal may for example be phase-shifted with respect to the first frequency f₁ of the magnetic field in such a way that it exactly compensates the (also phase shifted) crosstalk components in the output of the magnetic sensor element.

The invention further relates to the use of the magnetic sensor device described above for molecular diagnostics, biological sample analysis, or chemical sample analysis, particularly in body fluids (blood, saliva etc.) and cells. Molecular diagnostics may for example be accomplished with the help of magnetic beads that are directly or indirectly attached to target molecules.

These and other aspects of the invention will be apparent from and elucidated with reference to the embodiment(s) described hereinafter. These embodiments will be described by way of example with the help of the accompanying drawings in which:
- Figure 1: illustrates the principle of a biosensor with a magnetic sensor device according to the present invention;
- Figure 2: depicts a block diagram of the complete circuitry of a magnetic sensor device according to the present invention;
- Figure 3: shows a first embodiment of a sub-circuit of Figure 2 that is suited for high frequency sensor currents;
- Figure 4: shows a second embodiment of a sub-circuit of Figure 2 that is suited for low frequency sensor currents;
- Figure 5: shows an improved embodiment of the circuit of Figure 4 with a crosstalk suppression;
- Figure 6: shows a particular realization of a low pass filter;
- Figure 7: shows a particular realization of a high pass filter.

Like reference numbers in the Figures or numbers differing by integer multiples of 100 refer to identical or similar components.

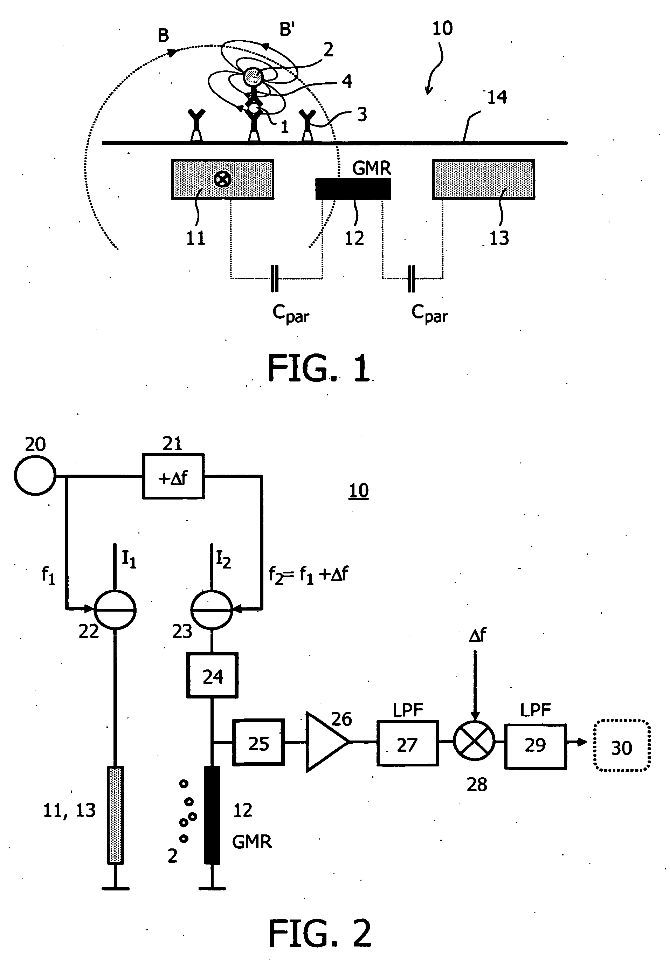

Figure 1 illustrates the principle of a single sensor 10 for the detection of superparamagnetic beads 2. A biosensor consisting of an array of (e.g. 100) such sensors 10 may be used to simultaneously measure the concentration of a large number of different target molecules 1 (e.g. protein, DNA, amino acids, drugs of abuse) in a solution (e.g. blood or saliva). In one possible example of a binding scheme, the so-called "sandwich assay", this is achieved by providing a binding surface 14 with first antibodies 3 to which the target molecules 1 may bind. Superparamagnetic beads 2 carrying second antibodies 4 may then attach to the bound target molecules 1. A current flowing in the wires 11 and 13 of the sensor 10 generates a magnetic field B, which then magnetizes the superparamagnetic beads 2. The stray field B' from the superparamagnetic beads 2 introduces an in-plane magnetization component in the GMR 12 of the sensor 10, which results in a measurable resistance change.

Figure 1 further illustrates by dashed lines and capacitors Cₚₐᵣ a parasitic capacitive coupling between the current wires 11, 13 and the GMR 12 (similarly an inductive coupling is present between these components, too). This coupling produces a crosstalk in the signal voltage of the GMR 12, wherein the crosstalk occurs at the frequency f₁ of the field generating current I₁ in the wires 11, 13. Disturbances by this crosstalk can be minimized if the sensor current I₂ flowing through the GMR 12 is also modulated with a second frequency f₂.

Figure 2 shows the schematic block diagram of a circuitry that can be used in connection with the magnetic sensor device 10 of Figure 1. Said circuitry comprises a current source 22 that is coupled to the conductor wires 11, 13 to provide them with a generator current I₁. Similarly, the GMR sensor 12 is coupled to a second current source or "sensor supply unit" 23 that provides the GMR 12 with a sensor current I₂. The signal of the GMR 12, i.e. the voltage drop across its resistance, is sent via an amplifier 26, an optional first low pass filter 27, a demodulator 28, and a second low pass filter 29 to the output 30 of the sensor device for final processing (e.g. by a personal computer).

The generator current I₁ is modulated with a first frequency f₁ that is generated by an modulation source 20. The signal of said modulation source 20 is further sent via a frequency shifter 21 to the second sensor current source 23 to modulate the sensor current I₂ with the second frequency f₂ = f₁ + Δf. As will not be explained in more detail here, the modulation of the sensor current with f₂ effects a shift of the desired magnetic signal of the GMR sensor 12 (inter alia) to the frequency difference Δf (the demodulator 28 is therefore fed with this frequency Δf). This shift allows to separate the signal from the capacitive and inductive crosstalk, which remains at f₁, and improves the achievable SNR.

Figure 2 further shows a first filter 24 between the current source 23 and the GMR sensor 12, which shall suppress noise from the current source 23, and a second filter 25 between the GMR sensor 12 and the amplifier 26 which shall suppress noise and unwanted frequency components in the signal of the GMR 12. These filters will be described in more detail in the following with respect to particular embodiments. It should be noted that due to filter 25, the filter 27 may become superfluous.

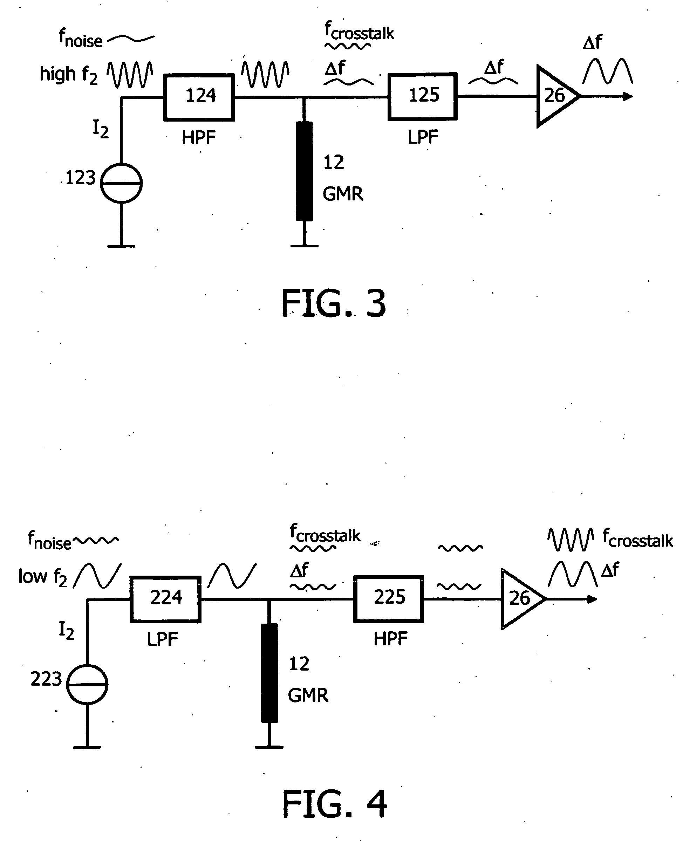

Figure 3 shows a first embodiment of a part of the circuit of Figure 2 that is particularly suited for high second frequencies f₂ (close to or higher than f₁), e.g. in the range of several MHz. A current source 123 generates the sensor current I₂. This is advantageous because the high output resistance of the current source 123 means that the gain of the magnetic signal (at Δf) from the GMR sensor 12 to the input of the amplifier 26 is 1, i.e. no magnetic signal flows through the current source 123. Due to extreme noise requirements of the sense signal (required noise level at the GMR: < -170 dBV/√Hz) it is however in practice very difficult to realize such a current source with e.g. a transistor.

To achieve the aforementioned requirements, the circuit of Figure 3 comprises a high pass filter (HPF) 124 between the current source 123 and the GMR sensor 12, and a low pass filter (LPF) 125 between the GMR sensor 12 and the amplifier 26. By applying the sensor current to the GMR sensor 12 via the HPF 124 (F_{-3dB} > Δf), the noise of the sensor current source at frequency fₙₒᵢₛₑ ≈ Δf can be reduced. In order to prevent signal loss from the sensor current source 123 to the GMR sensor 12, the LPF 125 (F_{-3dB} > Δf) is added in the signal path from the GMR sensor 12 to the input of the amplifier 26. The input impedance of the LPF 125 plus the input of the amplifier at the sensor current frequency f₂ should be significantly higher compared to the GMR impedance in order to prevent additional signal loss from the sensor current (f₂) to the GMR sensor 12. On the other hand the output impedance of the HPF 124 at frequency Δf should be significantly higher compared to the input impedance of the LPF 125 plus amplifier input in order to prevent additional signal loss of the magnetic signal (Δf) from the GMR sensor 12 to the amplifier output.

It is also possible to apply the sensor current via a voltage source instead of the current source 123. The requirements for the output impedance of the HPF at Δf and the input impedance of the LPF plus the amplifier at f₂ are the same for this case.

Another problem that is solved by applying filter 25 in Figure 2 is the large dynamic range of the signals on the input of the amplifier 26. The signal level of the magnetic signal (Δf) is in the order of µVolts, while the sense signal itself (I₂·R_{GMR} at frequency f₂) is around 1 Volt. Here R_{GMR} is the resistance of the GMR in the absence of a magnetic field. Due to inductive coupling and capacitive coupling of the field generating signal (f₁) a crosstalk signal arises at the GMR sensor 12 the amplitude of which increases linear with the frequency. In the active part of the electronics (first amplifier 26), the two frequency components at f₂ (sense signal) and at f₁ (field crosstalk signal) may lead to spurious components, especially at higher frequencies (large f₁ crosstalk signal). One of these spurious components that may be generated in the active part of the electronics lies at Δf = |f₂ - f₁|, which is an undesirable frequency component as it interferes with the magnetic signal at Δf that one wants to measure. By applying for instance the LPF 125 in Figure 3 as described above, the large dynamic range of the signals can significantly be reduced because f₁ and f₂ are both strongly attenuated by this LPF.

As a result of a sensor current with high frequency f₂, the magnetic signal will appear at a low frequency Δf = |f₂-f₁|. By applying two filters 124, 125 between the current source and the GMR sensor and between the GMR sensor and the (pre-)amplifier 26, a system is achieved that combines the following desired properties:
1. For high frequencies the impedance of the HPF is low, allowing the use of relatively small voltages to generate sufficient sensor current.
2. For low frequencies (frequencies of interest) the input impedance of the HPF is high, preventing the noise generated in the source to appear at the input of the pre-amplifier.
3. For low frequencies (frequencies of interest) the output impedance of the HPF is high, which results in a transfer of the magnetic signal to the input of the pre-amplifier equal to 1.
4. The dynamic range of the signal at the input of the pre-amplifier is low, as the large and high frequency sense signal (I₂·R_{GMR}) and crosstalk (f₁) is filtered out by the LPF.

If in an exemplary embodiment a sensor current with frequency f₂ = 1.05 MHz and a field frequency f₁ =1.00 MHz are used, the magnetic signal of interest will appear at Δf = 1.05 MHz - 1.00 MHz = 50 kHz. Thus a HPF with corner frequency just below 1.05 MHz and a LPF with a corner frequency just above 50 kHz should be used.

Figure 4 shows an alternative embodiment of a sub-circuit for Figure 2 which is particularly suited for low sensor frequencies f₂ (cf. WO 2005/010543 A1). It comprises the low pass filter LPF 224 between the current source 223 and the GMR sensor 12 on the one hand side and the high pass filter HPF 225 between the GMR sensor 12 and the amplifier 26 on the other hand side. With respect to the circuit of Figure 3, the LPF and the HPF have been interchanged. The purpose of the LPF 224 is now to reduce the noise from the sensor current source 223 at the frequencies of the magnetic signal (Δf = f₁-f₂; f₁+f₂). The HPF 225 reduces the sensor current signal (I₂·R_{GMR} at the low frequency f₂). The input impedance of the HPF 225 plus the amplifier input at frequency f₂ should be significantly higher compared to the GMR impedance in order to prevent additional signal loss from the sensor current source (f₂) to the GMR sensor 12. On the other hand, the output impedance of the LPF 224 at the frequencies f₁ ± f₂ should be significantly higher compared to the input impedance of the HPF 225 plus the amplifier input in order to prevent additional signal loss of the signal at f₁ ± f₂ from the GMR sensor 12 to the amplifier output. The reduction of the dynamic range only applies to the sensor current signal, which is strongly attenuated by the HPF.

As a result of a sensor current with low frequency f₂, the magnetic signal will appear at high frequencies Δf= f₁±f₂. By applying two filters 224, 225 between the current source 223 and the GMR sensor 12 and between the GMR sensor 12 and the (pre-)amplifier 26, a system is achieved that combines the following desired properties:
1. For low frequencies the impedance of the LPF is low, allowing the use of relatively small voltages to generate sufficient sensor current.
2. For high frequencies (frequencies of interest) the input impedance of the LPF is high, preventing the noise generated in the source to appear at the input of the pre-amplifier.
3. For high frequencies (frequencies of interest) the output impedance of the LPF is high, which results in a transfer of the magnetic signal to the input of the pre-amplifier equal to 1.
4. The dynamic range of the signal at the input of the pre-amplifier is lower, as the large and low frequency sense signal (I₂·R_{GMR}) is filtered out by the HPF.

If in an exemplary embodiment a sensor current with frequency f₂ = 50 kHz and a field frequency f₁ = 1.00 MHz are used, the magnetic signal of interest will appear at 1.00 MHz ± 50 kHz = 0.95 MHz and 1.05 MHz. Thus a HPF with corner frequency just below 0.95 MHz and a LPF with a corner frequency just above 50 kHz should be used.

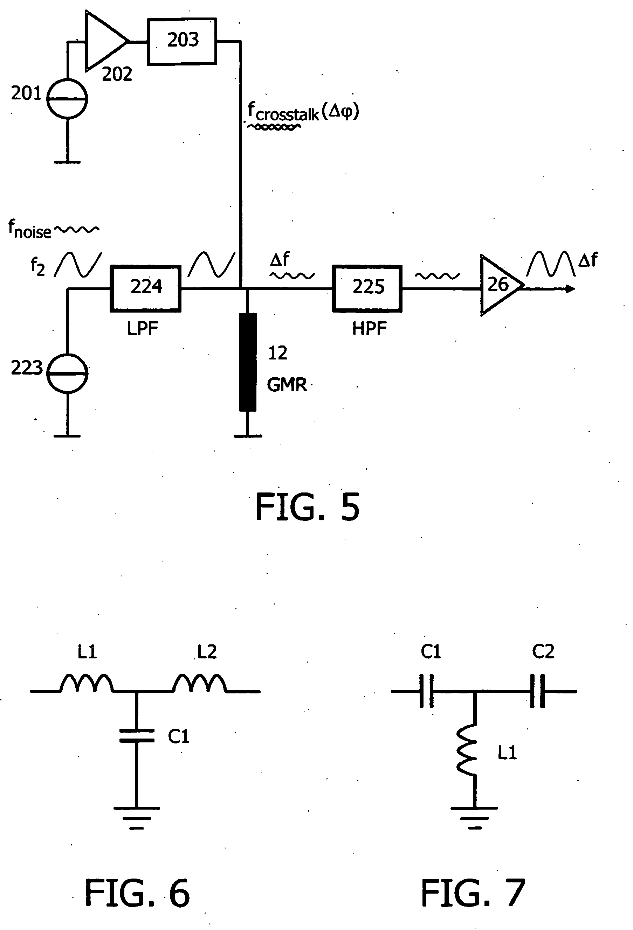

It should be noted that in the circuit of Figure 4 the crosstalk signal still appears at the input of the amplifier 225 and cannot easily be filtered out to decrease the dynamic range, as the frequency f₁ of this crosstalk is close to the frequency Δf of the magnetic signal. The crosstalk component can, however, be suppressed by adding a compensation signal as depicted in Figure 5. In the compensation circuit comprising a current source 201, an amplifier 202, and a delay 203, a signal with same frequency f_{crosstalk} = f₁ and amplitude as the crosstalk signal but in anti-phase Δϕ is used to cancel the crosstalk.

Figures 6 and 7 show examples of a 3rd order low pass filter and a high pass filter, respectively, that comprise just capacitors C1, C2, and inductors L1, L2, and that may be used to realize the filters 24, 124, 224, 25, 125, 225 of the previous Figures. Any other filter with a suited frequency characteristic and impedance may however also be used.

Finally it is pointed out that in the present application the term "comprising" does not exclude other elements or steps, that "a" or "an" does not exclude a plurality, and that a single processor or other unit may fulfill the functions of several means. The invention resides in each and every novel characteristic feature and each and every combination of characteristic features. Moreover, reference signs in the claims shall not be construed as limiting their scope.

## Claims

1. A magnetic sensor device (10), comprising
a) at least one magnetic field generator (11, 13) for generating a magnetic field (B) of a first frequency f₁ in an investigation region;
b) at least one associated magnetic sensor element (12); **characterized by**
c) a sensor supply unit (23, 123, 223) for providing an alternating sensor current of a second frequency f₂ to the magnetic sensor element (12) such that the output of the magnetic sensor element (12) contains a signal at the absolute frequency difference Af between the second and the first frequency, i.e. at Δf = |f₂ - f₁|;
d) a first filter (24, 124, 224) disposed between the sensor supply unit (23, 123, 223) and the magnetic sensor element (12) for preventing noise from reaching the magnetic sensor element (12).

2. The magnetic sensor device (10) according to claim 1,
**characterized in that** the first filter is a high pass filter (124) with an edge frequency above the frequency difference Δf.

3. The magnetic sensor device (10) according to claim 1,
**characterized in that** the first filter is a low pass filter (224) with an edge frequency below the frequency difference Δf.

4. The magnetic sensor device (10) according to claim 1,
**characterized in that** it comprises an amplifier (26) for amplifying an output signal of the magnetic sensor element (12).

5. The magnetic sensor device (10) according to claim 4,
**characterized in that** it comprises a second filter (25, 125, 225) disposed between the magnetic sensor element (12) and the amplifier (26) for preventing signal components of the second frequency f₂ from reaching the amplifier (26).

6. The magnetic sensor device (10) according to claim 5,
**characterized in that** the second filter is a low pass filter (125) with an edge frequency above the frequency difference Δf.

7. The magnetic sensor device (10) according to claim 5,
**characterized in that** the second filter is a high pass filter (225) with an edge frequency below the frequency difference Δf.

8. The magnetic sensor device (10) according to claim 5,
**characterized in that** the ratio between the input impedance of the second filter (25, 125, 225) together with the amplifier (26) and the impedance of the magnetic sensor element (12) is, at the second frequency f₂, larger than one, preferably larger than 100.

9. The magnetic sensor device (10) according to claim 5,
**characterized in that** the ratio between the output impedance of the first filter (24, 124, 224) and the input impedance of the second filter (25, 125, 225) together with the amplifier (26) is, at the frequency difference Δf, larger than one, preferably larger than 100.

10. The magnetic sensor device (10) according to claim 5,
**characterized in that** it comprises a compensation unit (201, 202, 203) connected to the magnetic sensor element (12) for supplying a crosstalk compensation signal of the first frequency f₁.

11. Use of the magnetic sensor device (10) according to any of the claims 1 to 10 for molecular diagnostics, biological sample analysis, or chemical sample analysis.

## Patentansprüche

1. Magnetresonanzeinrichtung (10), die Folgendes umfasst:
a) mindestens einen Magnetfeldgenerator (11, 13) zum Erzeugen eines Magnetfelds (B) einer ersten Frequenz f₁ in einer Untersuchungsregion;
b) mindestens ein zugehöriges Magnetsensorelement (12), **gekennzeichnet durch**
c) eine Sensorversorgungseinheit (23, 123, 223) zum Versorgen des Magnetsensorelements (12) mit einem Sensorwechselstrom einer zweiten Frequenz f₂ auf derartige Weise, dass der Ausgang des Magnetsensorelements (12) ein Signal mit einer absoluten Frequenzdifferenz Δf zwischen der zweiten und der ersten Frequenz, d.h. Δf= |f₂ - f₁|, enthält;
d) einen ersten Filter (24, 124, 224), der zwischen der Sensorversorgungseinheit (23, 123, 223) und dem Magnetsensorelement (12) angeordnet ist, um zu verhindern, dass Rauschen das Magnetsensorelement (12) erreicht.

2. Magnetsensoreinrichtung (10) nach Anspruch 1,
**dadurch gekennzeichnet, dass** der erste Filter ein Hochpassfilter (124) mit einer Randfrequenz ist, die größer ist als Frequenzdifferenz Δf.

3. Magnetsensoreinrichtung (10) nach Anspruch 1,
**dadurch gekennzeichnet, dass** der erste Filter ein Tiefpassfilter (224) mit einer Randfrequenz ist, die kleiner ist als die Frequenzdifferenz Δf.

4. Magnetsensoreinrichtung (10) nach Anspruch 1,
**dadurch gekennzeichnet, dass** sie einen Verstärker (26) zum Verstärken eines Ausgangssignals des Magnetsensorelements (12) umfasst.

5. Magnetsensoreinrichtung (10) nach Anspruch 4,
**dadurch gekennzeichnet, dass** sie einen zweiten Filter (25, 125, 225) umfasst, der zwischen dem Magnetsensorelement (12) und dem Verstärker (26) angeordnet ist, um zu verhindern, dass Signalkomponenten der zweiten Frequenz f₂ den Verstärker (26) erreichen.

6. Magnetsensoreinrichtung (10) nach Anspruch 5,
**dadurch gekennzeichnet, dass** der zweite Filter ein Tiefpassfilter (125) mit einer Randfrequenz ist, die größer ist als die Frequenzdifferenz Δf.

7. Magnetsensoreinrichtung (10) nach Anspruch 5,
**dadurch gekennzeichnet, dass** der zweite Filter ein Hochpassfilter (225) mit einer Randfrequenz ist, die kleiner als die Frequenzdifferenz Δf ist.

8. Magnetsensoreinrichtung (10) nach Anspruch 5,
**dadurch gekennzeichnet, dass** das Verhältnis zwischen der Eingangsimpedanz des zweiten Filters (25, 125, 225) zusammen mit dem Verstärker (26) und der Impedanz des zweiten Magnetsensorelements (12) bei der zweiten Frequenz f₂ größer als eins ist, vorzugsweise größer als 100.

9. Magnetsensoreinrichtung (10) nach Anspruch 5,
**dadurch gekennzeichnet, dass** das Verhältnis zwischen der Ausgangsimpedanz des ersten Filters (24, 124, 224) und der Eingangsimpedanz des zweiten Filters (25, 125, 225) zusammen mit dem Verstärker (26) bei der Frequenzdifferenz Δf größer als eins ist, vorzugsweise größer als 100.

10. Magnetsensoreinrichtung (10) nach Anspruch 5,
**dadurch gekennzeichnet, dass** sie eine mit dem Magnetsensorelement (12) verbundene Kompensationseinheit (201, 202, 203) umfasst, um ein Signal der ersten Frequenz f₁ zur Kompensation des Nebensprechens zu liefern.

11. Verwendung der Magnetsensoreinrichtung (10) nach einem der Ansprüche 1 bis 10 zur molekularen Diagnose, zur Analyse biologischer Proben oder zur Analyse chemischer Proben.

## Revendications

1. Dispositif de capteur magnétique (10) comprenant :
a) au moins un générateur de champ magnétique (11, 13) pour générer un champ magnétique (B) d'une première fréquence f₁ dans une région de recherche ;
b) au moins un élément de capteur magnétique associé (12) ;
c) une unité d'alimentation de capteur (23, 123, 223) pour fournir un courant alternatif de capteur d'une deuxième fréquence f₂ à l'élément de capteur magnétique (12) de telle façon que la sortie de l'élément de capteur magnétique (12) contienne un signal à la différence de fréquence absolue Δf entre la deuxième et la première fréquence, c'est-à-dire à Δf = |f₂ - f₁| ; **caractérisé par** :
d) un premier filtre (24, 124, 224) qui est disposé entre l'unité d'alimentation de capteur (23, 123, 223) et l'élément de capteur magnétique (12) afin d'éviter que du bruit n'atteigne l'élément de capteur magnétique (12).

2. Dispositif de capteur magnétique (10) selon la revendication 1,
**caractérisé en ce que** le premier filtre est un filtre passe-haut (124) avec une fréquence de pointe au-dessus de la différence de fréquence Δf.

3. Dispositif de capteur magnétique (10) selon la revendication 1,
**caractérisé en ce que** le premier filtre est un filtre passe-bas (224) avec une fréquence de pointe au-dessous de la différence de fréquence Δf.

4. Dispositif de capteur magnétique (10) selon la revendication 1,
**caractérisé en ce qu'**il comprend un amplificateur (26) pour amplifier un signal de sortie de l'élément de capteur magnétique (12).

5. Dispositif de capteur magnétique (10) selon la revendication 4,
**caractérisé en ce qu'**il comprend un deuxième filtre (25, 125, 225) qui est disposé entre l'élément de capteur magnétique (12) et l'amplificateur (26) afin d'éviter que des composantes de signal de la deuxième fréquence f₂ n'atteignent l'amplificateur (26).

6. Dispositif de capteur magnétique (10) selon la revendication 5,
**caractérisé en ce que** le deuxième filtre est un filtre passe-bas (125) avec une fréquence de pointe au-dessus de la différence de fréquence Δf.

7. Dispositif de capteur magnétique (10) selon la revendication 5,
**caractérisé en ce que** le deuxième filtre est un filtre passe-haut (225) avec une fréquence de pointe au-dessous de la différence de fréquence Δf.

8. Dispositif de capteur magnétique (10) selon la revendication 5,
**caractérisé en ce que** le rapport entre l'impédance d'entrée du deuxième filtre (25, 125, 225) conjointement avec l'amplificateur (26) et l'impédance de l'élément de capteur magnétique (12) est supérieur, à la deuxième fréquence f₂, à un, de préférence supérieur à 100.

9. Dispositif de capteur magnétique (10) selon la revendication 5,
**caractérisé en ce que** le rapport entre l'impédance de sortie du deuxième filtre (24, 124, 224) et l'impédance d'entrée du deuxième filtre (25, 125, 225) conjointement avec l'amplificateur (26) est supérieur, à la deuxième différence de fréquence Δf, à un, de préférence supérieur à 100.

10. Dispositif de capteur magnétique (10) selon la revendication 5,
**caractérisé en ce qu'**il comprend une unité de compensation (201, 202, 203) qui est reliée à l'élément de capteur magnétique (12) pour fournir un signal de compensation de diaphonie de la première fréquence f₁.

11. Utilisation du dispositif de capteur magnétique (10) selon l'une quelconque des revendications précédentes 1 à 10 pour le diagnostic moléculaire, l'analyse biologique d'échantillon ou l'analyse chimique d'échantillon.
